# EUROPEAN PATENT SPECIFICATION

(11) **EP 1 672 425 B1**
(45) Date of publication and mention of the grant of the patent: **11.07.2012**
(21) Application number: 05027196.4
(22) Date of filing: 13.12.2005
(51) Int. Cl.: G03F 7/00, B65H 5/00, B41F 27/12

(54) **Automatic supplying apparatus and method for supplying photosensitive printing plates**
Vorrichtung und Verfahren zur automatischen Zufuhr für lichtempfindliche Druckplatten
Appareil de fourniture automatique et procédé de fourniture de plaques d' impression photosensibles

(30) Priority: 14.12.2004 JP 2004361081
(43) Date of publication of application: 21.06.2006
(73) Proprietor: FUJIFILM Corporation, Minato-ku Tokyo (JP)
(72) Inventor: Kawamura, Yoshinori, Ashigarakami-gun, Kanagawa (JP); Itakura, Toru, Ashigarakami-gun, Kanagawa (JP); Komiyama, Kazuoki, Ashigarakami-gun, Kanagawa (JP); Matsuba, Kikuo, Ashigarakami-gun, Kanagawa (JP)
(74) Representative: Klunker . Schmitt-Nilson . Hirsch

(56) References cited:
- EP-A1- 1 327 594
- EP-A2- 0 955 564
- EP-A2- 1 130 471
- JP-A- 10 254 144
- US-A- 5 065 180
- US-B1- 6 623 003

## Description

### BACKGROUND OF THE INVENTION

### Field of the Invention

The present invention relates to an automatic supplying apparatus and method for photosensitive printing plates constituted such that a packaged article in which a plurality of photosensitive printing plates are arranged in a bundle and packaged by a packaging material in a light-shielding manner can be loaded in a bright room.

### Description of the Related Art

Ordinarily, in offset printing; a photosensitive printing plate (so-called PS plate) has been utilized. Further, in a planographic printing field, a CTP (Computer to Plate) system in which an unexposed photosensitive printing plate is supplied and, then, the thus-supplied photosensitive printing plate is subjected to a laser exposure process based on digital data of computer and the like and, subsequently, to a development process which converts a latent image formed on the photosensitive printing plate into a developed image to directly produce a printing plate by an automatic developing device has been put in practice.

This CTP system is sometimes provided with an automatic supplying apparatus for photosensitive printing plates. In the automatic supplying apparatus for photosensitive printing plates, a plurality of photosensitive printing plates are stacked one on top of another in a bundle and loaded in a housing of the automatic supplying apparatus in a light-shielding state and, along with start of a plate making operation, the photosensitive printing plates are separated sheet by sheet from the bundle of photosensitive printing plates by a sheet supplying mechanism of the automatic supplying apparatus and delivered to a side of an exposing process portion.

The photosensitive printing plate to be used in the CTP system is formed, for example, by applying a photosensitive layer on a thin aluminum plate and is exposed even with faint light to cause a change in the photosensitive layer and, further, has a property of causing a change in the photosensitive layer by absorbing a moisture in the air.

For this reason, in order to prevent the photosensitive printing plate from generating a quality change during a period of from being produced in a factory or the like, passing through distribution processes such as being transported and stored, until being loaded in the automatic supplying apparatus of the CTP system, predetermined plural number of photosensitive printing plates are arranged in a bundle and, then, cardboard (so-called abutting board made of corrugated cardboard) is provided on each of a front face and a rear face of the bundle and, thereafter, the resultant bundle is fastened by using a fixing device such as an adhesive tape, to thereby suppress deformation of the bundle.

Further, the bundle of photosensitive printing plates which has been provided with cardboard on front and rear faces and, then, fastened together by using an adhesive tape is packaged by the inner packaging paper having a light-shielding property and a moisture resistant property. As for such inner packaging paper, paper having a light-shielding property and a moisture resistant property, for example, an aluminum kraft paper in which polyethylene is melted and applied to kraft paper to adhere aluminum foil thereon or a black polyethylene laminated kraft paper or the like in which melted polyethylene mixed with black carbon is applied to kraft paper is used.

Still further, in order to prevent the photosensitive printing plate or an inner packaging paper from being broken or the like during a transportation process or a storage process from production of the photosensitive printing plate until loading thereof to a photosensitive printing plate supplying apparatus of an automatic plate making machine, a packaging box is separately produced and this packaging box accommodates the photosensitive printing plates packaged by the inner packaging paper. For the packaging box, for example, a box made of corrugated cardboard which is light in weight and high in strength has been used.

Even still further, in the packaging of conventional photosensitive printing plates, a device in which, when the packaged bundle of the photosensitive printing plates is loaded in the photosensitive printing plate supplying apparatus of the automatic plate making machine, in order to facilitate an operation of opening the packaging in a bright room, the bundle of photosensitive printing plates is packaged with a packaging material capable of being separated into two portions and, then, the bundle of photosensitive printing plates packaged with the packaging material capable of being separated into two portions is set in an inside of the photosensitive printing plate supplying apparatus of the automatic plate making machine and, after a lid is closed to allow the inside to be in a light-shielding state, by drawing out one portion of the packaging material capable of being separated into two portions which is projected from a slit of such closed lid, a portion of the packaging material can be taken out while keeping the inside of the photosensitive printing plate supplying apparatus in the light-shielding state is proposed (for example, refer to JP-A No. 11-314680).

Furthermore, in the conventional photosensitive printing plate supplying apparatus of the automatic plate making machine, a device, being capable of accommodating a bundle of photosensitive printing plates in a printing plate packaging box while keeping it in a light-shielding state and carrying the box in a bright room, in which, the package of the photosensitive printing plates is opened in a dark room and, then, cardboard (abutting board made of corrugated cardboard) is removed from each of the front and rear faces of the bundle of photosensitive printing plates and, thereafter, a plurality of photosensitive printing plates and a covering papaer are accommodated in a printing plate packaging box and, subsequently, an opening/closing lid of the box is closed to allow the box to be in a light-shielding state and, then, the box is carried into the photosensitive printing plate supplying apparatus of the automatic plate making machine placed in a bright room and, then, loaded in a printing plate supplying cassette provided inside the photosensitive printing plate supplying apparatus and, thereafter, a door of the photosensitive printing plate supplying apparatus is closed to allow the inside of the photosensitive printing plate supplying apparatus to be in a light-shielding state and, subsequently, the opening/closing lid of the printing plate packaging box is opened by an automatic apparatus and, then, the photosensitive printing plates are separated sheet by sheet from the bundle of photosensitive printing plates accommodated inside the printing plate packaging box by a sheet supplying mechanism of the automatic supplying apparatus and, thereafter, delivered to a side of an exposing process portion is proposed (for example, refer to JP-A No.11-314771).

However, in the conventional device of removing a portion of the packaging material while keeping the inside of the photosensitive printing plate supplying apparatus in a light-shielding state as described above, a structure in which cardboard (abutting board made of corrugated cardboard) is removed from the surface of the bundle of photosensitive printing plates from which the packaging material is taken out while keeping the inside of the photosensitive printing plate supplying apparatus in a light-shielding state and, then, stored in a disposal site is complicated and requires an additional large automatic apparatus and, therefore, there is a problem in that the CTP system provided with the photosensitive printing plate supplying apparatus becomes larger and expensive.

Further, in the device capable of accommodating the bundle of photosensitive printing plates in the printing plate packaging box while keeping it in a light-shielding state and carrying the box in a bright room, when the bundle of photosensitive printing plates is provided in the photosensitive printing plate supplying apparatus, an operator takes out the bundle of photosensitive printing plates packaged with the inner packaging material from a stored packaging box of, for example, a box made of corrugated cardboard. Next, the operator loads the bundle of photosensitive printing plates packaged with the inner packaging paper in the printing plate packaging box. At the time of such operation, in order to prevent photosensitive faces of the photosensitive printing plates from being exposed, namely, fogged by light, it is necessary to perform the loading operation in a dark room (under a dark lamp) and, therefore, the operator moves to a dark room carrying the bundle of photosensitive printing plates packaged with the inner packaging paper and the printing plate packaging box.

The operator opens the inner paper under the dark lamp in the dark room and, then, takes out therefrom an article in which cardboard (so-called abutting board made of corrugated cardboard) is provided to each of the front and rear faces of the bundle of photosensitive printing plates and fastened with an adhesive tape to suppress the deformation of the bundle. Thereafter, the operator removes the adhesive tape and, subsequently, removes cardboard provided to each of the front and rear faces of the bundle. The operator accommodates the bundle of predetermined number of photosensitive printing plates in the printing plate packaging box and closes the opening/closing lid.

Next, the operator loads the printing plate packaging box accommodating the bundle of photosensitive printing plates in the printing plate supplying cassette provided inside the photosensitive printing plate supplying apparatus and, thereafter, the door of the photosensitive printing plate supplying apparatus is closed to allow the inside of the photosensitive printing plate supplying apparatus to be in a light-shielding state and, subsequently, the opening/closing lid of the printing plate packaging box is opened by an automatic apparatus and, then, the photosensitive printing plates are separated sheet by sheet from the bundle of photosensitive printing plates accommodated inside the printing plate packaging box by a sheet supplying mechanism of the automatic supplying apparatus and, thereafter, delivered to a side of the exposing process portion.

In the device capable of accommodating the bundle of photosensitive printing plates in the printing plate packaging box while keeping it in a light-shielding state and carrying the box in the bright room, since the operator is required to operate under the dark lamp in the dark room, a facility of the dark room is necessary and, therefore, cost becomes high and it is much troublesome and takes time to open the package. In the conventional device for supplying the bundle of photosensitive printing plates, since it is necessary to manually handle the bundle of a plurality of photosensitive printing plates stacked one on top of another which weighs to 20 kg at the maximum, the thus-stacked photosensitive printing plates are moved such that they come relatively out of alignment from one another to generate a risk of causing a scar on a photosensitive face of the photosensitive printing plate or damage due to abutting with another article. Further, under the dark lamp, since the operator can not see well, working efficiency is inferior and, then, there is a possibility of generating an error in loading the photosensitive printing plate.

Further, in the device capable of accommodating the photosensitive printing plates in the printing plate packaging box attached with an opening/closing lid while keeping it in a light-shielding state and carrying the box in a bright room, since it is necessary to separately provide an automatic opening/closing apparatus for the opening/closing lid which is complicated in structure and large in size for performing an opening operation of the opening/closing lid in the photosensitive printing plate supplying apparatus, there is a problem in that the CTP system provided with the photosensitive printing plate supplying apparatus becomes larger in size and higher in cost.

There is further prior art related to an apparatus for supplying photosensitive printing plates. EP 0 955 564 A2 discloses an apparatus which uses as packaging material a box having a lid extending over one half of one surface of the box. The lid may be opened by means of a suction apparatus. After having opened the lid, the printing plates can be removed from the interior of the box one by one, also by making use of a suction device. EP 1 327 594 A1 discloses a similar apparatus.

EP 1 130 471 A2 discloses an exposure apparatus for printing plates having a printing plate accommodation section in which a printing plate accommodation cassette comprises a shutter which may be opened and closed at an opening of the cassette.

US 6,623,003 B1 discloses an exposure apparatus similar to that shown in EP '471 mentioned above.

### SUMMARY OF THE INVENTION

Under these circumstances, the present invention provides a novel automatic supplying apparatus for photosensitive printing plates which allows a bundle of photosensitive printing plates to be loaded in a bright room, can enhance working efficiency, allows a structure to be compact, can be smaller and can be produced at a lower cost.

The invention provides an automatic supplying apparatus for photosensitive printing plates, containing: the features of claim 1.

By providing such constitution as described above, in the automatic supplying apparatus placed in a bright room, even when the photosensitive printing plates are loaded in the automatic supplying apparatus in a bright room in a state of being packaged by the packaging material, the packaging material is opened in the automatic supplying apparatus while keeping a light-shielding state and cardboard or the like which protects the surface of the bundle of photosensitive printing plates is not entirely removed, an operation of delivering each photosensitive printing plate can easily efficiently be performed. Further, in the automatic supplying apparatus, since an article in which the photosensitive printing plates and a protective member on which an opening is formed are packaged with a packaging material provided with a packaging device capable of conveniently opening is provided, the automatic supplying apparatus can open a portion of the packaging material and execute an operation for delivering each photosensitive printing plate with a simple constitution and, therefore, the automatic supplying apparatus can be smaller in size and can be produced at low cost.

The invention also provides an automatic supplying method for photosensitive printing plates having the features of claims 7.

### BRIEF DESCRIPTION OF THE DRAWINGS

A preferred embodiment of the present invention will be described in detail based on the following figures, wherein:
FIG. 1 is a schematic diagram showing an overall CTP (Computer to Plate) system provided with an automatic supplying apparatus for photosensitive printing plates according to the invention,
FIG. 2 is a schematic constitutional diagram showing, as a whole, an inside of a CTP (Computer to Plate) system provided with an automatic supplying apparatus for photosensitive printing plates according to the invention,
FIG. 3 is an enlarged schematic constitutional diagram of a main portion showing a state in which a bundle of photosensitive printing plates packaged with a packaging material is loaded in an automatic supplying apparatus of the photosensitive printing plates according to the invention,
FIG. 4 is an enlarged schematic constitutional diagram of a main portion showing a state in which a bundle of photosensitive printing plates packaged with a packaging material is set in an automatic supplying apparatus of a photosensitive printing plates according to the invention such that a lead portion of a second packaging material can be drawn out,
FIG. 5 is an enlarged schematic constitutional diagram of a main portion showing a state in which a second packaging material is drawn out from a bundle of photosensitive printing plates packaged with a packaging material set in an automatic supplying apparatus of photosensitive printing plates according to the invention,
FIG. 6 is a perspective diagram showing a state in which a bundle of photosensitive printing plates completely packaged with a packaging material used in an automatic supplying apparatus of photosensitive printing plates according to invention is put in an outer box,
FIG. 7 is a vertical cross-sectional diagram showing a state in which a bundle of predetermined plural number of photosensitive printing plates is packaged with a packaging material, to be used in an automatic supplying apparatus of photosensitive printing plates according to the invention, and
FIG. 8 is a perspective diagram showing a state by being cut out in which a protective member provided with a simple package-opening device for conveying photosensitive printing plates is stacked on predetermined plural number of photosensitive printing plates and, then, arranged in a bundle, to be used in an automatic supplying apparatus of photosensitive printing plates according to the invention.

### DETAILED DESCRIPTION OF THE INVENTION

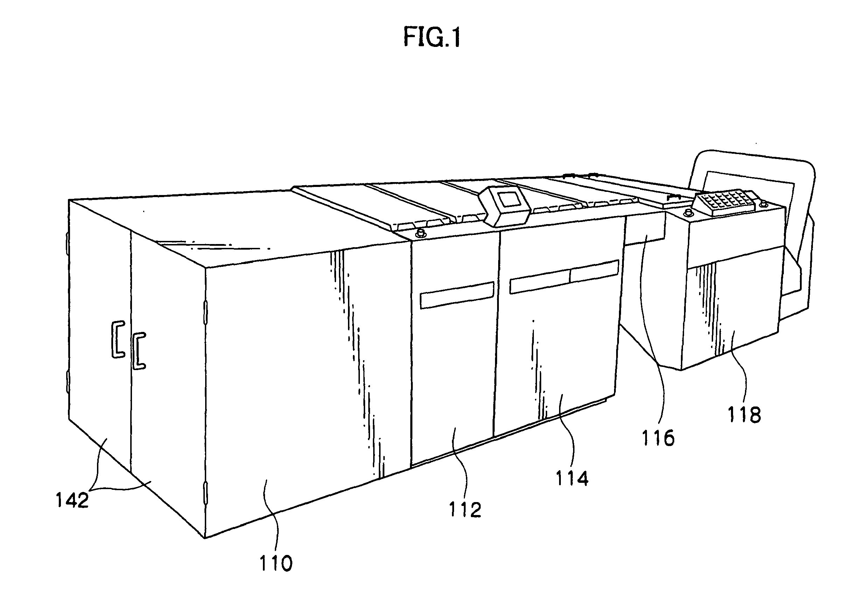

Embodiments of an automatic supplying apparatus for photosensitive printing plates according to the present invention will be described with reference to FIGS. 1 to 8. The automatic supplying apparatus for photosensitive printing plates according to the present embodiment is constituted such that, with respect to an article which is loaded as it is in a bright room in a state in which a protective member such as a cardboard for protecting a surface of a photosensitive face is provided and a predetermined plural number of photosensitive printing plates are packaged in a bundle with a packaging material such as an inner packaging paper, the packaging material can be opened and a conveying operation can be performed for delivering each photosensitive printing plate, without entirely removing the cardboard which protect a surface of the bundle of the photosensitive printing plates.

The photosensitive printing plate 10 to be subjected to a conveying in the automatic supplying apparatus for photosensitive printing plates is constituted as a so-called PS plate or photopolymer plate in which a photosensitive face 10A formed by applying an image recording layer containing a photosensitive material on a support which is a thin aluminum plate formed in a rectangular planar shape having a predetermined size.

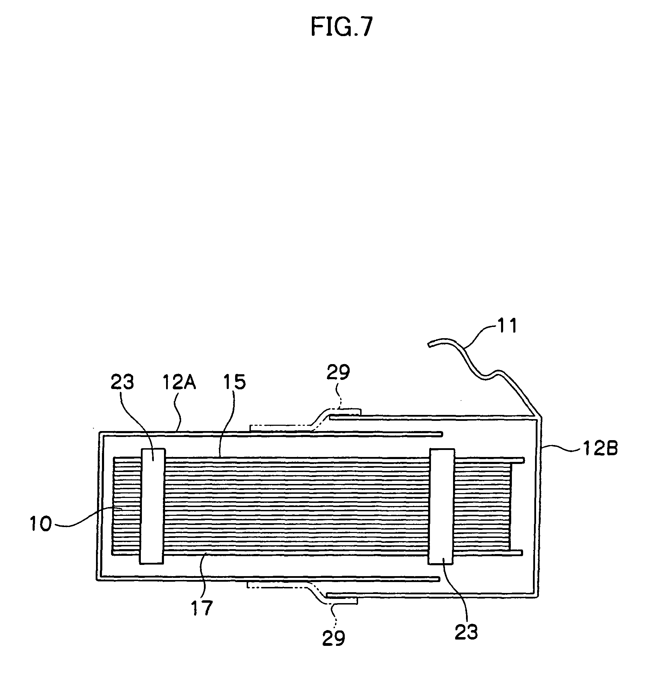

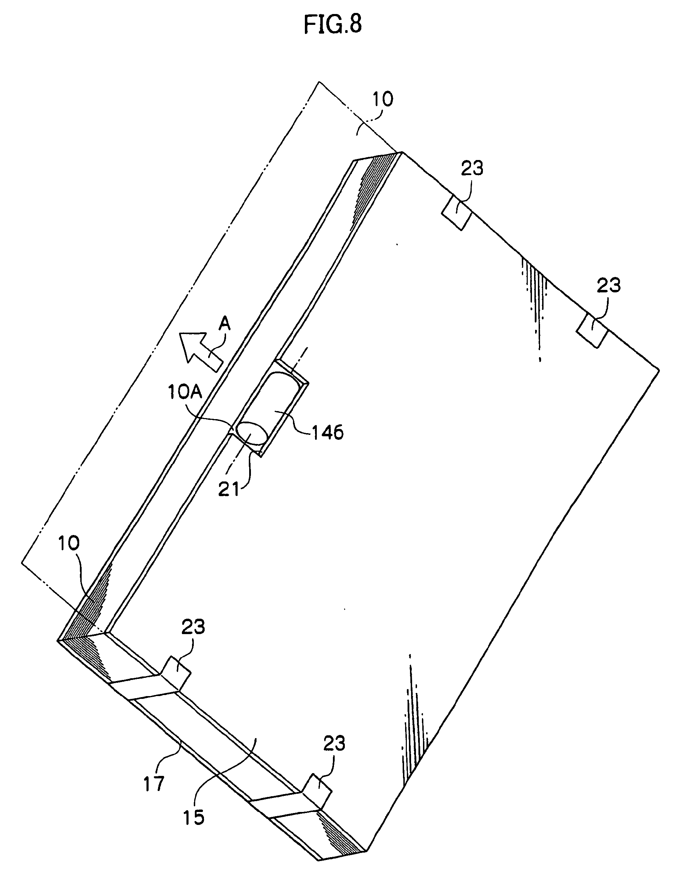

As shown in FIGS. 7 and 8, predetermined plural number of photosensitive printing plates 10 are stacked one on top of another to be arranged into, for example, a bundle of rectangular parallelepiped.

As the photosensitive printing plate 10 to be used in the automatic supplying apparatus for photosensitive printing plates, a so-called covering paper-less PS plate is used which is a photopolymer PS plate in which a photosensitive face 10A formed by coating a surface of the PS plate with a photosensitive agent is stronger against an outer force (20 times or more) compared with that of, for example, a currently commercially available PS plate, and which does not require protection by covering papers.

In the predetermined plural number of printing plates 10 to be arranged in a bundle of a rectangular parallelepiped stacked with no covering paper, a protective member 15 is provided on the photosensitive face 10A of the photosensitive printing plate 10 placed on the top of the bundle and, optionally, the protective member 17 is also provided on a rear face (aluminum face) of the photosensitive printing plate 10 at the bottom of the bundle of the predetermined plural number of photosensitive printing plates 10.

These protective members 15 and 17 are each formed in a planar shape having a similar shape as that of photosensitive plate 10 by using a so-called abutting board made of corrugated cardboard which is a material having a light-shielding property and a moisture resistant property in a planar shape or cardboard or the like having a light-shielding property and a moisture resistant property.

In a case in which it is necessary to bind the bundle of the predetermined plural number of photosensitive printing plates 10 in which the protective member 15 is provided at a side of the photosensitive face 10A and the protective member 17 is provided at a side of the rear face together, a fastening device such as an adhesive tape 23 is attached such that it starts from a surface of the protective member 15, passes through a side face of the predetermined plural number of photosensitive printing plates 10 in a bundle and reaches a surface of the protective member 17. Further, as for a position to be fastened by the fastening device such as the adhesive tape 23, four positions are shown in FIG. 8; however, the number may either be increased or decreased as the occasion arises.

As shown in FIG. 8, the predetermined plural number of photosensitive printing plates 10 bundled together in which the protective member 15 is provided at a side of the photosensitive face 10A and the protective member 17 is provided at a side of a rear side are constituted such that photosensitive printing plates 10 can be drawn out sheet by sheet from such bundle by the automatic supplying apparatus in the CTP system and delivered to a next exposing step or the like.

Namely, a simple package-opening device for conveying of the photosensitive printing plates is constituted such that the predetermined plural number of photosensitive printing plates 10 bundled together in which the protective member 15 is provided at a side of the photosensitive face 10A and the protective member 17 is provided at a side of a rear side can be subjected to a conveying operation for delivering each photosensitive printing plate without entirely removing the protective member 15 provided at the side of the photosensitive face 10A.

The simple package-opening device for conveying of the photosensitive printing plates as shown in FIG. 8 is constituted in correspondence with a delivering device which is attached to the automatic supplying apparatus or the like of the CTP system, contacts an uppermost photosensitive printing plate 10 in the bundle of the photosensitive printing plate 10, separates one from the others, and then conveys it to the sheet supplying apparatus or the like.

The delivering device can, for example, as shown in FIG. 8, be constituted as a roller for delivering 146 composing a so-called roller pick (delivering member) which contacts the photosensitive printing plate 10 positioned on the top of the bundle of the photosensitive printing plates 10 in a rolling manner, separates one from the others, and then delivers it.

The simple package-opening device for conveying of the photosensitive printing plates to be constituted in correspondence with the delivering device can, for example, as shown in FIG. 8, be constituted by forming an opening 21 having a little large size than that of the delivering roller 146 which is the delivering member in a central portion at a side of a leading end in a direction of conveying the protective member 15.

Further, in the simple package-opening device for conveying of the photosensitive printing plates, the opening 21 may be constituted over an entire length in a width direction by cutting an end portion at a downstream side in the conveying direction of the protective member 15 along an entire length. Namely, in this case, the protective member 15 is constituted to be shorter by a predetermined length than the entire length along the conveying direction of the photosensitive printing plates 10.

Still further, a material of a packaging material 12 which packages an article in which a predetermined plural number of photosensitive printing plates 10 in which the protective member 15 is provided at a side of the photosensitive face 10A and the protective member 17 is provided at a side of the rear face are bundled together and, then, the simple package-opening device for conveying of the photosensitive printing plates is provided in the protective member 15 is, for example, constituted by an article having the predetermined light-shielding property and moisture resistant property which is prepared by attaching a metallic thin film such as an aluminum foil on at least one face of paper (for example, kraft paper) having a predetermined strength.

Even still further, the material of the packaging material 12 preferably does not substantially change characteristics (for example, fogging, sensitivity change, and the like) of the photosensitive printing plates 10 by performing a chemical reaction with the photosensitive printing plates 10. As for materials which satisfy all of these conditions, for example, a material in which linear low density polyethylene is applied on a kraft paper in a thin film manner, a material in which a moisture resistant agent is applied on the kraft paper, a material in which a moisture resistant agent and a light-shielding agent are applied on the kraft paper, a material in which a linear low density polyethylene added with 3 % by weight of carbon black is applied on the kraft paper, a material in which a linear low density polyethylene is applied on a light-shielding paper or a black-colored paper, a black stretched polypropylene (OPP) film and the like can be mentioned.

As for the moisture resistant agent used in the packaging material 12, for example, an aqueous emulsion containing a synthetic rubber type latex or a resin type latex and a wax type emulsion and a mixture of an acrylic emulsion and a wax type emulsion can be mentioned.

Further, as for the light-shielding agent to be used in the packaging material 12, particularly, a material capable of absorbing or reflecting light having a same wavelength as a photosensitive wavelength of the photosensitive layer of the photosensitive printing plates 10 is preferable. For example, in a case in which an diazo photosensitive material is used as the photosensitive layer of the photosensitive printing plates 10, a light-shielding agent containing at least one of a pigment (chrome yellow, benzine yellow, or the like) and a dye can be used which selectively shields light having the wavelength region of from 250 to 500 nm which is a photosensitive wavelength of this diazo photosensitive material.

The light-shielding paper to be used as the packaging material 12 includes a paper which contains about 5 to 10 % of carbon black and reduces the number of pinholes due to increased refinement of the paper and thus increases light-shielding properties. The amount of carbon black to be contained may be increased or decreased in accordance with the number, density, size of the pinholes, or the like. The black paper includes a black kraft paper which is manufactured by adding a black dye in a paper manufacturing process, a paper which is printed in black onto a kraft paper, or the like.

Some kinds of black dye, the black ink, or the like may contain a material which causes chemical reactions with the photosensitive printing plate 10 that substantially change the characteristics of the photosensitive printing plate 10. Therefore, it is desirable to use a black dye or a black ink which does not include such material or which includes only a small amount thereof in which amount the chemical reaction of the photosensitive printing plate 10 does not substantially become a problem. Further, the weight of the light-shielding paper or the black paper is preferably from about 70 to about 150 g/m².

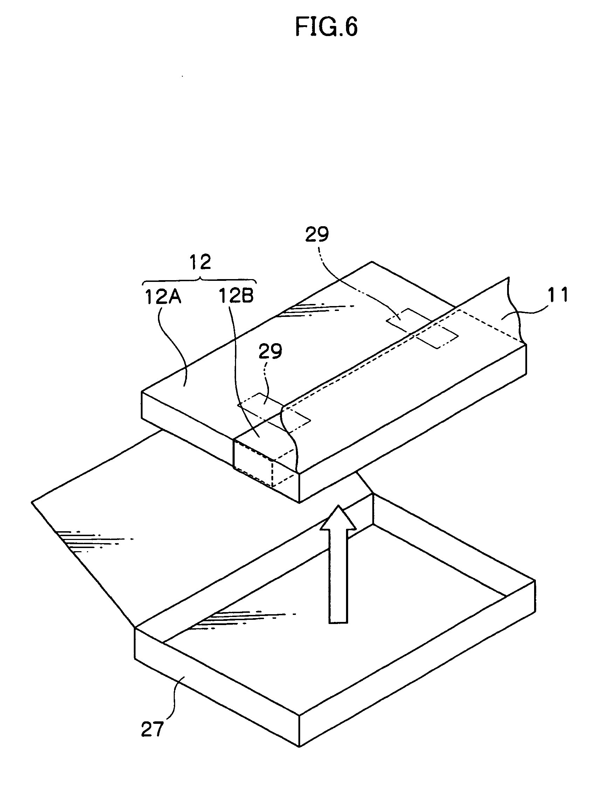

As for a packaging device capable of performing a simple package-opening of the packaging material which packages a bundle of the predetermined plural number of photosensitive printing plates by utilizing the simple package-opening device for conveying of the photosensitive printing plates using the packaging material 12 constituted by such materials as described above, for example, as shown in FIGS. 6 and 7, packaging by using two packaging materials 12 can be utilized.

Namely, in a packaging device capable of performing a simple package-opening of this packaging material, a first packaging material 12A which packages a portion at an upstream side in a conveying direction of a bundle of the protective members 15 and 17 and the photosensitive printing plates and a second packaging material 12B which packages a portion at a downstream side in a conveying direction of a bundle of the protective members 15 and 17 and the photosensitive printing plates are combined to constitute a unified packaging. Further, in the packaging device capable of performing a simple package-opening of the packaging material 12, at the time of the package-opening, the packaging material 12 may be constituted such that it is separated into 3 or more plural pieces and at least one portion is removed.

The first packaging material 12A is formed in a rectangular box shape having a size which can packages a portion at an upstream side in the conveying direction from the opening 21 to expose the opening 21 provided in the protective member 15.

The second packaging material 12B packages the opening 21 provided in the protective member 15 and extends to an area which partially overlaps with a portion which the first packaging material 12A packages and is formed in a rectangular box shape having a size capable of packages a portion at a downstream side in the conveying direction from the opening 21.

Further, in the second packaging material 12B, a lead portion 11 for performing a drawing-out operation formed in a rectangular band state is provided such that it extends out from an edge portion at a downstream side in a conveying direction.

When packaging is performed by a packaging device capable of performing a simple package-opening by using the first packaging material 12A and the second packaging material 12B, for example, a portion at an upstream side in the conveying direction of a bundle of the protective members 15 and 17 and the photosensitive printing plates is covered with the first packaging material 12A and a portion at a downstream side in the conveying direction of a bundle of the protective members 15 and 17 and the photosensitive printing plates is covered with the second packaging material 12B and, then, a portion in which a free edge portion of the first packaging material 12A and a free edge portion of the second packaging material 12B are folded one on the other is fastened by using a temporary fixing device 29 which is detachable by peeling off by an outer force having a predetermined strength such as an adhesive tape whose adhesive force is adjusted to perform a packaging as one body.

Further, as for the packaging device capable of performing a simple package-opening of the packaging material in which a bundle of the predetermined plural number of photosensitive printing plates utilizing the simple package-opening device for conveying of the photosensitive printing plates is packaged such that it can be separated into two portions, for example, a device described in JP-A No. 11-314680 paragraphs from 0041 to 0046 in which, by performing packaging by using two packaging materials, when the package is opened, by separating and drawing out one of two packaging materials 12A and 12B (see FIG. 7) which are in a packaging state, a portion is allowed to be exposed in the bundle of the predetermined plural number of photosensitive printing plates utilizing the simple package-opening device for conveying of the photosensitive printing plates can be utilized.

Still further, as shown in FIG. 6, by putting the bundle of the photosensitive printing plates 10 packaged by using the first packaging material 12A and the second packaging material 12B in a outer box 27 formed by using a material having a predetermined rigidness such as a corrugated cardboard, resin or the like and protecting it, transportation or storage thereof can efficiently be performed.

As described above, an article in which the bundle of the predetermined plural number of photosensitive printing plates utilizing the simple package-opening device for conveying of the photosensitive printing plates is packaged by using a packaging device capable of performing the simple package-opening of the packaging material such that it can be separated into two portions is favorable for being supplied to the CTP (Computer to Plate) system which performs a laser exposing process on the basis of digital data of computer or the like and, then, performs a developing process for converting a latent image formed on the photosensitive printing plate into a developed image by using an automatic developing machine to directly form a printing plate.

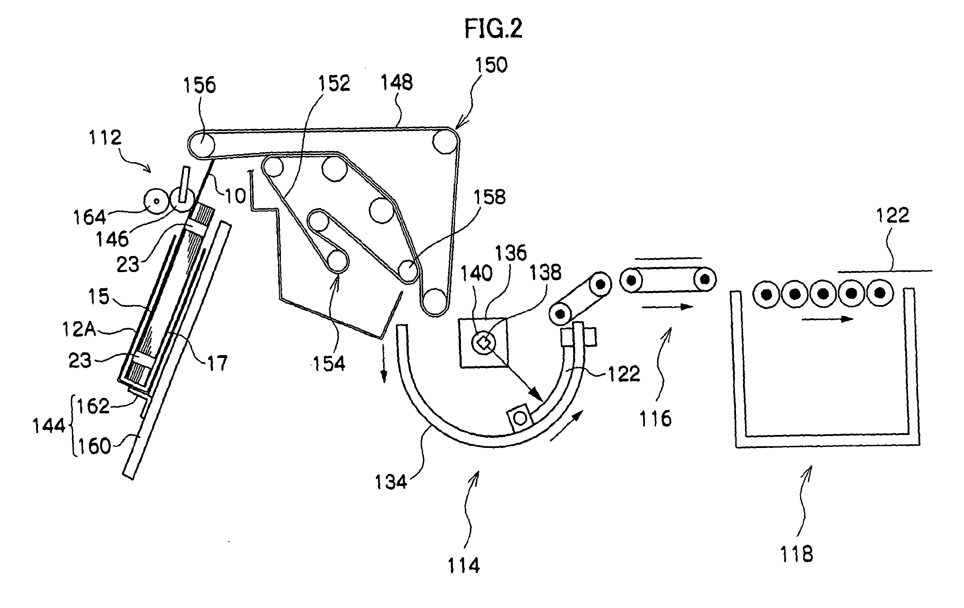

As shown in FIGS. 1 and 2, this CTP system contains an automatic supplying apparatus 110 in which a packaged bundle of photosensitive printing plates 10 is supplied, a sheet supplying apparatus 112 which separates the photosensitive printing plates 10 (PS plates) sheet by sheet from the bundle of photosensitive printing plates 10 and supplies them, an inner drum exposing apparatus (monogonal scanner) 114, a buffer apparatus 116 and a developing process apparatus 118.

The automatic supplying apparatus 110 of this CTP system is inside provided with a sheet supplying apparatus 112. In order to constitute the sheet supplying apparatus 112, in an inside of the automatic supplying apparatus 110, a storage shelf 144 is provided. The storage shelf 144 is constituted by attaching a shelf member 162 on a support 160 which is slantingly provided from a floor of the automatic supplying apparatus 110 to an upper portion of the inner drum exposing apparatus 114 such that height can be adjusted.

When the bundle of photosensitive printing plates 10 packaged by the first packaging material 12A and the second packaging material 12B is placed on the thus-constituted storage shelf 144, as shown in figures, an edge portion at an upstream side in a delivering direction of the bundle is placed on the shelf member 162 and allowed to slantingly lean against a surface of the support 160.

Further, in the sheet supplying apparatus 112, at a predetermined position in an upper side of the storage shelf 144, a roller 146 for delivering (pickup roller) is attached so as to be displaceably operatable between a pickup position and a recess position of the photosensitive printing plates 10. Still further, in a predetermined position in the vicinity of the roller 146 for delivering, a roller 164 for discharging which is a discharging member for opening the package by removing the second packaging material 12B is attached.

In the sheet supplying apparatus 112, the roller 146 for delivering contacts in a rolling manner the photosensitive printing plates 10 present on the top of the bundle of the photosensitive printing plates 10 placed on the storage shelf 144, separates one sheet and, then, conveys it into a conveyor belt winding mechanism.

In the conveyor belt winding mechanism, in order to convey each photosensitive printing plate 10 from the storage shelf 144 to the inner drum exposing apparatus 114, a main conveyor belt winding mechanism 150 around which a main conveyor belt 148 is wound and an auxiliary conveyor belt winding mechanism 154 around which an auxiliary belt 152 is wound are provided.

The main conveyor belt winding mechanism 150 constitutes a conveying path by winding the conveyor belt 148 between a receiving position of the photosensitive printing plates 10 which corresponds to an upper portion of the storage shelf 144 and a delivering position into the inner drum exposing apparatus 114.

Further, the auxiliary conveyor belt winding mechanism 154 is constituted such that the photosensitive printing plates 10 are prevented from being dropped in the course of conveyance by sharing a portion of a conveying path provided under the main conveyor belt 148 in the main conveyor belt winding mechanism 150.

For this account, the auxiliary conveyor belt winding mechanism 154 is constituted by being wound such that the main conveyor belt 148 and the auxiliary conveyor belt 152 travel side by side in an area between an intermediate roller 156 at an upstream side in a conveying direction from a guide area which is abutted with a leading edge of each photosensitive printing plate 10 delivered from the storage shelf 144 and an intermediate roller 158 close to a discharging port of a conveying path provided underneath the main conveyor belt 148.

When the bundle of photosensitive printing plates 10 is loaded in the automatic supplying apparatus 110 provided with the sheet supplying apparatus 112 constituted as described above, the operator takes out the bundle of the photosensitive printing plates 10 packaged with the packaging materials 12A and 12B from the outer box 27 and prepares.

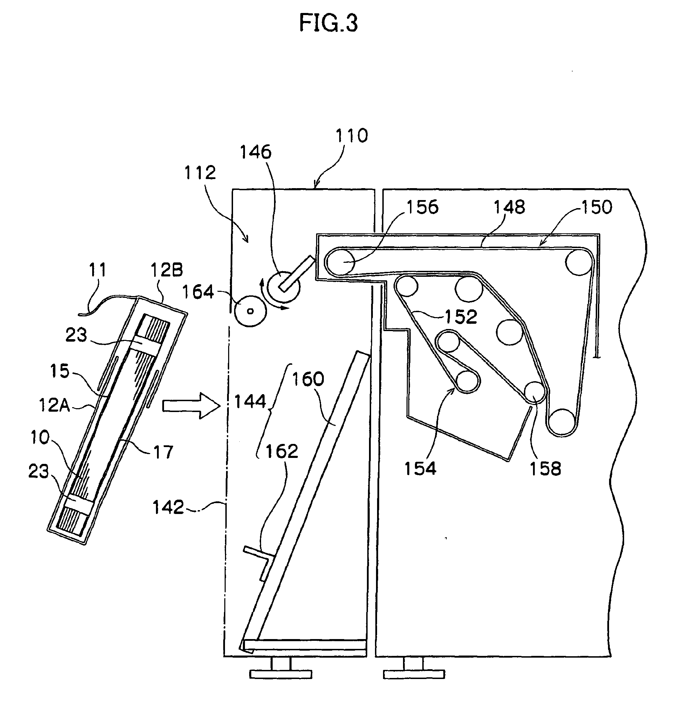

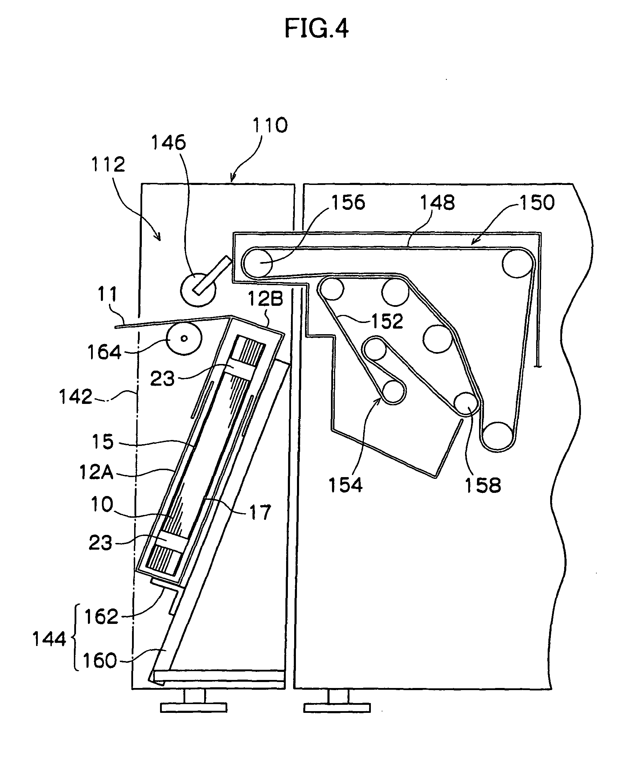

Next, the operator opens a door 142 of the automatic supplying apparatus 110 and, as FIGS. 3 and 4 show, puts the bundle of photosensitive printing plates 10 on the storage shelf 144 which is slantingly arranged in the inside thereof and, then, shuts the door 142 to shield light to allow the inside of the automatic supplying apparatus 110 to be a dark room. At this moment, the roller 146 for delivery is recessed to a recessed position.

Also, at this moment, a lead portion 11 of the second packaging material 12B which packages the bundle of the predetermined plural number of photosensitive printing plates by utilizing the simple package-opening device for conveying of the photosensitive printing plates is set such that it passes over a roller 164 for discharging which is a discharging device as shown in FIG. 4, passes through a through-hole (not shown in detail) having a light-shielding property provided at an upper side of the door 142 and is, then, led to outside of the automatic supplying apparatus 110. The second packaging material 12B which is drawn out by the roller 164 for discharging may be temporarily stored in a place which does not give any influence to a delivery operation of the photosensitive printing plates 10 inside the automatic supplying apparatus 110.

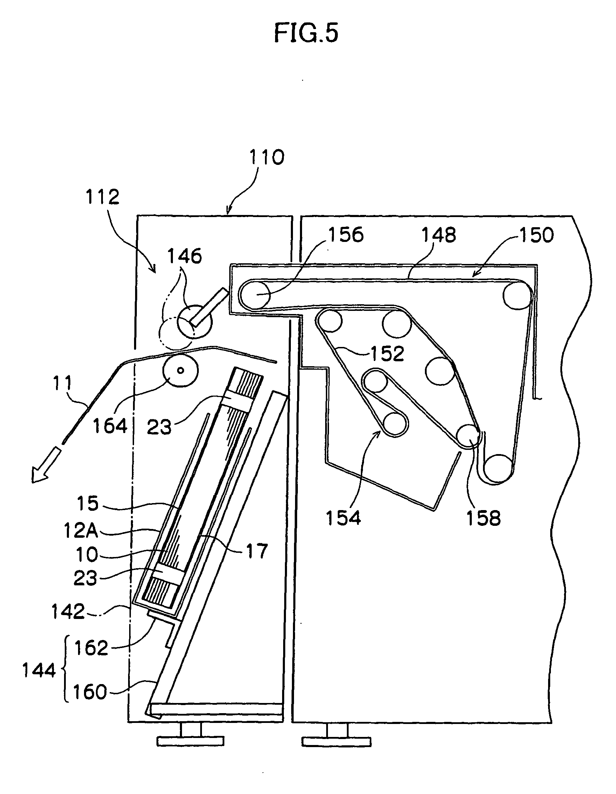

Next, by driving the roller 164 for discharging from the state as shown in FIG. 4, the second packaging material 12B is taken out from the bundle of the photosensitive printing plates by pulling the lead portion 11 as shown FIG. 5 and is disposed outside the automatic supplying apparatus 110. In a state as shown in FIG. 5, an upper portion in the bundle of the predetermined plural number of photosensitive printing plates in which the simple package-opening device for conveying of the photosensitive printing plates is utilized comes to be in a state of being exposed inside the automatic supplying apparatus 110 (as FIG. 8 shows, a state in which the roller 146 which is moved to a pick-up position can be housed in the opening 21). Further, a temporary fixing device 29 which temporarily fixes the first packaging material 12A and the second packaging material 12B which package the bundle of the photosensitive printing plates 10 can be separated by hand and, then, the bundle may be set inside the automatic supplying apparatus 110. In the occasion, an operation of removing the first packaging material 12A by pulling the lead portion 11 by the roller 164 for discharging can be facilitated.

Further, the operation of taking out the second packaging material 12B from the bundle of the photosensitive printing plates by pulling the lead portion 11 by the roller 164 for discharging may, as shown in a phantom line in FIG. 5, be performed by pinching the lead portion 11 between the roller 164 for delivering and the roller 146 for delivering.

Next, as described above, in the automatic supplying apparatus 110 in which the bundle of the predetermined plural number of photosensitive printing plates in which the simple package-opening device for conveying of the photosensitive printing plates is utilized is loaded on the storage shelf 144, as shown in FIG. 2, the roller 146 for delivering which is displaced to a pick-up position is allowed to contact in a rolling manner the photosensitive face 10A which is exposed inside the opening 21 of the protective member 15 and to perform an operation of delivering each photosensitive printing plate 10 without removing the protective member 15.

Therefore, as described above, in the bundle of the predetermined plural number of photosensitive printing plates containing the packaging device capable of performing the simple opening of the package material and the simple package-opening device for conveying of the photosensitive printing plates, the second packaging material 12B is opened in a space in which light is shielded inside the automatic supplying apparatus 110 in a bright room and the photosensitive printing plates 10 are delivered sheet by sheet.

As described above, by allowing the packaging material which packages the bundle of the photosensitive printing plates 10 in a light-shielding state to be opened, the operator can perform a package-opening operation in a bright environment. Therefore, work efficiency is enhanced, compared with opening the package in a dark environment, to thereby reduce a load to be put on the operator. Further, since it is not necessary to put an entire room in which the CTP system is installed in a dark environment, when other works than that described above are conducted, it is not necessary to stop the work and, accordingly, work efficiency is prevented from being reduced.

In this CTP system, since an automatic apparatus in which the packaging material is taken off from the bundle of the photosensitive printing plates 10 in a light-shielding state and is kept in stock in the automatic supplying apparatus 110, while another device in a light-shielding state (another function) is not necessary which takes out of the protective member 15 from the bundle of the photosensitive printing plates 10, the apparatus can be smaller by that much, can be produced at low cost and, since time to be consumed for removing the protective member 15 can be omitted, work efficiency can be enhanced.

As FIG 2 shows, in the automatic supplying apparatus 110, the roller 146 for delivering which is in a pick-up position contacts in a rotating manner the photosensitive printing plate 10 present on top of the bundle of the photosensitive printing plates 10 and conveys one sheet into the main conveyor belt winding mechanism 150. In the main conveyor belt winding mechanism 150, a leading edge of the one photosensitive printing plate 10 separated by the roller 146 for delivering abuts the guide area of the main belt 148 and is conveyed to a side of the intermediate roller 156 along with a traveling operation of the main conveyor belt 148.

The photosensitive printing plates 10 in which a leading edge is guided by the main conveyor belt 148 is conveyed on a conveying path in a state of being pinched between the main conveyor belt 148 and the auxiliary conveyor belt 152 at the position of the intermediate roller 156 and is freed from the state of being pinched at the position of the intermediate roller 158 near a discharging port and, then, carried in the inner drum exposing apparatus 114.

The inner drum exposing apparatus 114 in this CTP system is constituted with a support 134 of a circular arc inner circumferential face shape (shape constituting a portion of cylindrical inner circumferential face) as a matrix and, then, the photosensitive printing plate 10 is supported along an inner circumferential face of the support 134.

In the inner drum exposing apparatus 114, the photosensitive printing plate 10 which is an unrecorded recording medium comes to be in contact with the inner circumferential face of the support 134 in a sure manner by a vacuum adsorbing device (not shown) and, after being held in a state of being along with the inner circumferential face, is subjected to an exposing process.

In this inner drum exposing apparatus 114, a spinner mirror apparatus 136 as a light beam deflecting device is provided in the center position of the circular arc of the support 134. This spinner mirror apparatus 136 is constituted such that a rotary shaft 140 in which a reflecting mirror member (spinner mirror) 138 is arranged in a top face is constituted rotatably at a high speed by a motor as a driving source in which rotation is controlled by a spinner driver of a controlling apparatus (not shown). The spinner mirror apparatus 136 is constituted such that a rotation center axis of the rotation shaft 140 corresponds to a circular arc central axis of the support 134.

In the spinner mirror apparatus 136, a light beam emitted from an optical system at a light source side is reflected on a face of the reflecting mirror of a pivoting reflecting mirror member 138 and performs a scanning exposure in a main scanning direction against the photosensitive face of the photosensitive printing plates 10.

The spinner mirror apparatus 136 performs an auxiliary scanning by an auxiliary scanning transfer device (not shown), while being controlled to move at a uniform velocity in an axis line (in a direction of passing through from a surface to a rear face in FIG. 2) of the circular arc center axis of the support 134.

For this account, in the spinner mirror apparatus 136, not only rotation of the motor thereof is controlled by the spinner driver of the control unit, but also transfer thereof in the auxiliary scanning direction is controlled by an auxiliary transfer device (not shown).

In the spinner mirror apparatus 136 constituted as described above, a light beam modulated in accordance with an image information projected from the optical system at a light source side is reflected on the reflection face of the pivoting reflecting mirror 138 and performs a scanning exposure in a main scanning direction and, at the same time, by moving the spinner mirror apparatus 136 in an auxiliary direction, a two dimensional image recording process can be performed on an entire recording face of the photosensitive printing plate 10.

The buffer apparatus 116 provided in this CTP system has a function of carrying the photosensitive printing plate 10 which is subjected to exposure by the inner drum exposing apparatus 114 into the developing process apparatus 118 at a required timing by adjusting a conveying speed.

The developing process apparatus 118 performs a developing process on the thus-carried-in photosensitive printing plate 10 which has been exposed and changes a latent image into a developed image, to thereby form a printing plate.

Although the present invention has been described with reference to a specific embodiment, it should not be construed that the present invention is limited to this embodiment.

Namely, a first aspect of the invention is an automatic supplying apparatus for photosensitive printing plates, containing: a sheet supplying portion in which a light-shielding state is maintained, the sheet supplying portion, containing:
a storage shelf on which can be placed a packaged article comprising a bundle of a plurality of photosensitive printing plates stacked one on top of another such that photosensitive faces are arranged to face one predetermined side, a protective member which is formed with a planar material, provided at a side of the photosensitive faces of the bundle of photosensitive printing plates and has an opening formed such that predetermined portions of the photosensitive faces of the photosensitive printing plates are exposed, and a packaging material which packages the bundle of photosensitive printing plates and the protective member, in which the packaging material is formed such that it can be separated into a plurality of portions, one portion thereof has a lead member attached thereto, and by pulling the lead member, the one portion can be removed to open the packaged article;
a discharging device for opening the packaged article by removing the one portion of the packaging material by means of pulling the lead member attached to the one portion of the packaging material; and
a delivering device for conveying, sheet by sheet, the photosensitive printing plates exposed at the opening of the protective member from the bundle of photosensitive printing plates in a state in which the one portion of the packaging material is removed.

The above-described aspect may be such that a through-hole having a light-shielding property which leads to outside is formed at a portion of the sheet supplying portion, and the lead member is set to be in a state of being led to the outside through the through-hole in the discharging device.

By constituting as described above, taking out a portion of the packaging material by pulling the lead portion led out outside through a through-hole having a light-shielding property of the automatic supplying apparatus is enabled by a manual operation and, accordingly, an apparatus inside the automatic supplying apparatus is simplified and, then, can be provided at low cost.

Further, the above-described aspect may be such that the delivering device comprises a conveying roll provided near the opening of the packaged article placed on the storage shelf.

Still further, the above-described aspect may be such that the opening is provided in a central portion at a conveying-direction leading edge side of the protective member.

Even still further, the above-described aspect may be such that the opening is provided over an entire length of an edge portion at a conveying-direction leading edge side of the protective member.

Furthermore, the above-described aspect may be such that the discharging device comprises a discharging roll.

A second aspect of the invention is an automatic supplying method for photosensitive printing plates which is performed by an automatic supplying apparatus in which a packaged article containing a bundle of a plurality of photosensitive printing plates stacked one on top of another such that photosensitive faces are arranged to face one predetermined side, a protective member which is formed with a planar material, provided at a side of the photosensitive faces of the bundle of photosensitive printing plates and has an opening formed such that predetermined portions of the photosensitive faces of the photosensitive printing plates are exposed, and a packaging material which packages the bundle of photosensitive printing plates and the protective member, in which the packaging material is formed such that it can be separated into a plurality of portions, one portion thereof has a lead member attached thereto, and by pulling the lead member, the one portion can be removed to open the packaged article, is placed in a sheet supplying portion of the automatic supplying apparatus having the sheet supplying portion in which a light-shielding state is maintained, the automatic supplying method having:
exposing the opening of the protective member by opening the packaging material by means of removing the one portion of the packaging material by pulling the lead member attached to the one portion of the packaging material; and
conveying, sheet by sheet, the photosensitive printing plates exposed at the opening of the protective member from the bundle of photosensitive printing plates.

Further, the above-described aspect may be such that such conveying includes conveying by a conveying roller provided in the vicinity of the opening of the packaged article placed in the sheet supplying portion.

Still further, the above-described aspect may be such that the opening is provided in a central portion at a conveying-direction leading edge side of the protective member.

Even still further, the above-described aspect may be such that the opening is provided over an entire length of an edge portion at a conveying-direction leading edge side of the protective member.

According to the automatic supplying apparatus of the photosensitive printing plates of the invention, the bundle of the photosensitive printing plates is allowed to be loaded in the bright room to enhance the work efficiency and the automatic supplying apparatus can be simpler and smaller and, then, can be manufactured at low cost.

## Claims

1. An automatic supplying apparatus for photosensitive printing plates (10), comprising: a sheet supplying portion (112) in which a light-shielding state is maintained, the sheet supplying portion, comprising:
a storage shelf (144) on which can be placed a packaged article comprising a bundle of a plurality of photosensitive printing plates (10) stacked one on top of another such that photosensitive faces are arranged to face one predetermined side, a protective member (15) which is formed with a planar material, provided at a side of the photosensitive faces of the bundle of photosensitive printing plates (10) and has an opening (21) formed such that predetermined portions of the photosensitive faces of the photosensitive printing plates (10) are exposed, and a packaging material (12) which packages the bundle of photosensitive printing plates (10) and the protective member (15), in which the packaging material is formed such that it can be separated into a plurality of portions (12A, 12B), one portion thereof has a lead member (11) attached thereto, and by pulling the lead member (11), the one portion (12B) can be removed to open the packaged article;
a discharging device (164) adapted to open the packaged article by removing the one portion (12B) of the packaging material by means of pulling the lead member (11) attached to the one portion of the packaging material; and
a delivering device (146) for conveying, sheet by sheet, the photosensitive printing plates (10) exposed at the opening (21) of the protective member (15) from the bundle of photosensitive printing plates (10) in a state in which the one portion (12B) of the packaging material is removed.

2. The automatic supplying apparatus for photosensitive printing plates according to claim 1, wherein a through-hole having a light-shielding property which leads to outside is formed at a portion of the sheet supplying portion (112), and the lead member (11) is set to be in a state of being led to the outside through the through-hole in the discharging device.

3. The automatic supplying apparatus for photosensitive printing plates according to Claim 1, wherein the delivering device (146) comprises a conveying roll provided near the opening (21) of the packaged article placed on the storage shelf (144).

4. The automatic supplying apparatus for photosensitive printing plates according to Claim 1, wherein the opening (21) is provided in a central portion at a conveying-direction leading edge side of the protective member (15).

5. The automatic supplying apparatus for photosensitive printing plates according to Claim 1, wherein the opening is provided over an entire length of an edge portion at a conveying-direction leading edge side of the protective member (15).

6. The automatic supplying apparatus for photosensitive printing plates according to Claim 1, wherein the discharging device (164) comprises a discharging roll.

7. An automatic supplying method for photosensitive printing plates (10) which is performed by an automatic supplying apparatus in which a packaged article comprising a bundle of a plurality of photosensitive printing plates (10) stacked one on top of another such that photosensitive faces are arranged to face one predetermined side, a protective member (15) which is formed with a planar material, provided at a side of the photosensitive faces of the bundle of photosensitive printing plates (10) and has an opening (21) formed such that predetermined portions of the photosensitive faces of the photosensitive printing plates (10) are exposed, and a packaging material (12) which packages the bundle of photosensitive printing plates (10) and the protective member (15), in which the packaging material is formed such that it can be separated into a plurality of portions (12A, 12B) one portion (12B) thereof has a lead member (11) attached thereto, and by pulling the lead member (11), the one portion can be removed to open the packaged article, is placed in a sheet supplying portion of the automatic supplying apparatus having the sheet supplying portion (112) in which a light-shielding state is maintained, the automatic supplying method comprising:
exposing the opening of the protective member by opening the packaging material by means of removing the one portion (12B) of the packaging material by pulling the lead member (11) attached to the one portion (12B) of the packaging material (10): and
conveying, sheet by sheet, the photosensitive printing plates (10) exposed at the opening of the protective member from the bundle of photosensitive printing plates (10).

8. The automatic supplying method for photosensitive printing plates according to Claim 7, wherein the conveying includes conveying by a conveying roller (146) provided in the vicinity of the opening (21) of the packaged article placed in the sheet supplying portion (112).

9. The automatic supplying method for photosensitive printing plates according to Claim 7, wherein the opening is provided in a central portion at a conveying-direction leading edge side of the protective member.

10. The automatic supplying method for photosensitive printing plates according to Claim 7, wherein the opening is provided over an entire length of an edge portion at a conveying-direction leading edge side of the protective member.

## Patentansprüche

1. Automatische Zuführvorrichtung für photoempfindliche Druckplatten (10), umfassend:
einen Bogenzuführteil (112), in welchem ein vor Licht abgeschirmter Zustand aufrecht erhalten ist, wobei der Bogenzuführteil umfasst:
ein Speicherfach (144), auf dem ein verpackter Artikel platzierbar ist, der ein Bündel aus einer Mehrzahl photoempfindlicher Druckplatten (10), die in der Weise übereinandergestapelt sind, dass photoem- pfindliche Flächen einer vorbestimmten Seite zugewandt sind, ein Schutzelement (15) aus flachstückartigem Material an einer Seite der photoempfindlichen Flächen des Bündels photoempfindlicher Druckplatten (10), und eine Öffnung (21) aufweist, die derart ausgebildet ist, dass vorbestimmte Abschnitte der photoempfindlichen Flächen der photoempfindlichen Druckplatten (10) freiliegen, und ein Verpackungsmaterial (11), welches das Bündel photoempfindlicher Druckplatten (10) und das Schutzelement (15) umhüllt, vorgesehen ist, wobei das Verpackungsmaterial derart ausgebildet ist, dass es sich in eine Mehrzahl von Abschnitten (12A, 12B) auftrennen lässt, von denen ein Abschnitt ein daran angebrachtes Führungselement (11) ist, und der eine Abschnitt (12B) durch Ziehen des Führungselements (11) entfernt werden kann, um den verpackten Artikel zu öffnen;
eine Auspackeinrichtung (164), ausgebildet zum Öffnen des verpackten Artikels durch Entfernen des einen Abschnitts (12B) des Verpackungsmaterials durch Ziehen des an dem einen Abschnitt des Verpackungsmaterials befestigten Führungselements (11); und
eine Fördereinrichtung (146) zum bogenweisen Befördern der photoempfindlichen Druckplatten (10), die an der Öffnung (21) des Schutzelements (15) freiliegen, aus dem Bündel der photoempfindlichen Druckplatten (10) in einem Zustand, in welchem der eine Abschnitt (12B) des Verpackungsmaterials entfernt ist.

2. Automatische Zuführvorrichtung für photoempfindliche Druckplatten nach Anspruch 1, bei dem ein Lichtabschirmeigenschaft aufweisendes Durchgangsloch, welches nach außen führt, in einem Bereich des Bogenzuführteils (122) ausgebildet ist, und das Führungselement (11) eingerichtet ist in einem Zustand, in welchem es durch das Durchgangsloch in der Auspackeinrichtung nach außen geführt ist.

3. Automatische Zuführvorrichtung für photoempfindliche Druckplatten nach Anspruch 1, bei der die Fördereinrichtung (146) eine Transportwalze in der Nähe der Öffnung (21) des auf dem Speicherfach (144) befindlichen verpackten Artikels aufweist.

4. Automatische Zuführvorrichtung für photoempfindliche Druckplatten nach Anspruch 1, bei der die Öffnung (21) in einem Mittelbereich an einer Seite der in Förderrichtung vorderen Kante des Schutzelements (15) vorgesehen ist.

5. Automatische Zuführvorrichtung für photoempfindliche Druckplatten nach Anspruch 1, bei der die Öffnung sich über die gesamte Länge eines Randbereichs auf der Seite der in Förderrichtung vorderen Kante des Schutzelements (15) erstreckt.

6. Automatische Zuführvorrichtung für photoempfindliche Druckplatten nach Anspruch 1, bei der die Auspackeinrichtung (164) eine Auftragwalze aufweist.

7. Automatisches Zuführverfahren für photoempfindliche Druckplatten (10), welches von einer automatischen Zuführvorrichtung ausgeführt wird, in der ein verpackter Artikel, in dem ein Bündel aus mehreren photoempfindlichen Druckplatten (10) derart übereinander gestapelt ist, dass photoempfindliche Flächen einer vorbestimmten Seite zugewandt sind, ein aus einem flachstückartigen Werkstoff gebildetes Schutzelement (15) an einer Seite der photoempfindlichen Flächen des Bündels der photoempfindlichen Druckplatten (10) vorgesehen ist und eine Öffnung (21) derart ausgebildet ist, dass vorbestimmte Abschnitte der photoempfindlichen Flächen der photoempfindlichen Druckplatten (10) freiliegen, und ein Verpackungsmaterial aufweist, welches das Bündel photoempfindlicher Druckplatten (10) und das Schutzelement (15) umhüllt, wobei das Verpackungsmaterial derart ausgebildet ist, dass es sich in eine Mehrzahl von Abschnitten (12A, 12B) trennen lässt, von denen ein Abschnitt (12B) ein daran angebrachtes Führungselement (11) besitzt, und durch Ziehen des Führungselements (11) der eine Abschnitt zum Öffnen des verpackten Artikels entfernt werden kann, in einem Bogenzuführteil der automatischen Zuführvorrichtung mit dem Bogenzuführteil (112) platziert ist, in welchem ein vor Licht abgeschirmter Zustand aufrecht erhalten wird, wobei das automatische Zuführverfahren umfasst:
Freilegen der Öffnung des Schutzelements durch Öffnen des Verpackungsmaterials, in dem der eine Abschnitt (12B) des Verpackungsmaterials entfernt wird, indem das Führungselement (11), welches an dem einen Abschnitt (12B) des Verpackungsmaterials befestigt ist, gezogen wird; und
bogenweises Zuführen der photoempfindlichen Druckplatten (11), die an der Öffnung des Schutzelements freiliegen, aus dem Bündel photoempfindlicher Druckplatten (10).

8. Automatisches Zuführverfahren für photoempfindliche Druckplatten nach Anspruch 7, bei dem das Befördern mit Hilfe einer Förderwalze (146) erfolgt, die in der Nähe der Öffnung (21) des in dem Bogenzuführteil (112) platzierten verpackten Artikels vorgesehen ist.

9. Automatisches Zuführverfahren für photoempfindliche Druckplatten nach Anspruch 7, bei dem die Öffnung in einem Mittelbereich an einer Seite der Vorderkante in Transportrichtung des Schutzelements vorgesehen ist.

10. Automatisches Zuführverfahren für photoempfindliche Druckplatten nach Anspruch 7, bei dem die Öffnung sich über die gesamte Länge eines Randbereichs auf der Seite der Vorderkante in Transportrichtung des Schutzelements erstreckt.

## Revendications

1. Appareil de fourniture automatique pour plaques d'impression photosensibles (10) comprenant : une partie de fourniture de feuille (112) dans laquelle un état de protection contre la lumière est maintenu, la partie de fourniture de feuille comprenant :
une étagère de stockage (144) sur laquelle peut être placé un article emballé comprenant un paquet d'une pluralité de plaques d'impression photosensibles (10) empilées les unes sur les autres de sorte que les faces photosensibles sont agencées pour faire face à un côté prédéterminé, un élément de protection (15) qui est formé avec un matériau plan, prévu sur un côté des faces photosensibles du paquet de plaques d'impression photosensibles (10) et a une ouverture (21) formée de sorte que les parties prédéterminées des faces photosensibles des plaques d'impression photosensibles (10) sont exposées, et un matériau d'emballage (12) qui emballe le paquet de plaques d'impression photosensibles (10) et l'élément de protection (15), dans lequel le matériau d'emballage est formé de sorte qu'il peut être séparé en une pluralité de parties (12A, 12B), l'une de ses parties a un élément de tête (11) fixé à cette dernière et en tirant l'élément de tête (11), la une partie (12B) peut être retirée pour ouvrir l'article emballé ;
un dispositif de décharge (164) adapté pour ouvrir l'article emballé en retirant la une partie (12B) du matériau d'emballage au moyen de la traction de l'élément de tête (11) fixé à la une partie du matériau d'emballage ; et
un dispositif de distribution (146) pour transporter, feuille par feuille, les plaques d'impression photosensibles (10) exposées à l'ouverture (21) de l'élément de protection (15) du paquet de plaques d'impression photosensibles (10) dans un état dans lequel la une partie (12B) du matériau d'emballage est retirée.

2. Appareil de fourniture automatique pour plaques d'impression photosensibles selon la revendication 1, dans lequel un trou de passage ayant une propriété de protection contre la lumière qui mène à l'extérieur, est formé au niveau d'une partie de la partie de fourniture de feuille (112) et l'élément de tête (11) est placé afin d'être dans un état dans lequel il est mené à l'extérieur par le trou de passage dans le dispositif de décharge.

3. Appareil de fourniture automatique pour plaques d'impression photosensibles selon la revendication 1, dans lequel le dispositif de distribution (146) comprend un rouleau de transport prévu à proximité de l'ouverture (21) de l'article emballé placé sur l'étagère de stockage (144).

4. Appareil de fourniture automatique pour plaques d'impression photosensibles selon la revendication 1, dans lequel l'ouverture (21) est prévue dans une partie centrale du côté du bord de tête dans le sens du transport de l'élément de protection (15).

5. Appareil de fourniture automatique pour plaques d'impression photosensibles selon la revendication 1, dans lequel l'ouverture est prévue sur toute la longueur d'une partie de bord du côté du bord de tête dans le sens du transport de l'élément de protection (15).

6. Appareil de fourniture automatique pour plaques d'impression photosensibles selon la revendication 1, dans lequel le dispositif de décharge (164) comprend un rouleau de décharge.

7. Procédé de fourniture automatique pour plaques d'impression photosensibles (10) qui est réalisé par un appareil de fourniture automatique dans lequel un article emballé comprenant un paquet d'une pluralité de plaques d'impression photosensibles (10) empilées les unes sur les autres de sorte que les faces photosensibles sont agencées pour faire face à un côté prédéterminé, un élément de protection (15) qui est formé avec un matériau plan, prévu sur un côté des faces photosensibles du paquet de plaques d'impression photosensibles (10) et a une ouverture (21) formée de sorte que des parties prédéterminées des faces photosensibles des plaques d'impression photosensibles (10) sont exposées, et un matériau d'emballage (12) qui emballe le paquet de plaques d'impression photosensibles (10) et l'élément de protection (15), dans lequel le matériau d'emballage est formé de sorte qu'il peut être séparé en une pluralité de parties (12A, 12B), l'une de ses parties (12B) a un élément de tête (11) fixé à cette dernière, et en tirant l'élément de tête (11), la une partie peut être retirée pour ouvrir l'article emballé, est placée dans une partie de fourniture de feuille de l'appareil de fourniture automatique ayant la partie de fourniture de feuille (112) dans lequel un état de protection contre la lumière est maintenu, le procédé d'alimentation automatique comprenant les étapes consistant à :
exposer l'ouverture de l'élément de protection en ouvrant le matériau d'emballage au moyen du retrait de la une partie (12B) du matériau d'emballage en tirant l'élément de tête (11) fixé à la une partie (12B) du matériau d'emballage ; et
transporter, feuille à feuille, les plaques d'impression photosensibles (10) exposées au niveau de l'ouverture de l'élément de protection du paquet de plaques d'impression photosensibles (10).

8. Procédé de fourniture automatique pour plaques d'impression photosensibles selon la revendication 7, dans lequel le transport comprend le transport par un rouleau de transport (146) prévu à proximité de l'ouverture (21), de l'article emballé placé dans la partie de fourniture de feuille (112).

9. Procédé de fourniture automatique pour plaques d'impression photosensibles selon la revendication 7, dans lequel l'ouverture est prévue dans une partie centrale d'un côté du bord de tête dans le sens du transport de l'élément de protection.

10. Procédé de fourniture automatique pour plaques d'impression photosensibles selon la revendication 7, dans lequel l'ouverture est prévue sur toute une longueur d'une partie de bord du côté du bord de tête dans le sens du transport de l'élément de protection.
